# EUROPEAN PATENT APPLICATION

(11) **EP 4 812 004 A1**
(43) Date of publication of application: **23.09.2026**
(21) Application number: 25196120.7
(22) Date of filing: 14.08.2025
(51) Int. Cl.: H10P 72/76

(54) **TRANSFER DEVICE AND METHOD OF MANUFACTURING SEMICONDUCTOR DEVICE**

(30) Priority: 18.03.2025 JP 2025043153
(71) Applicant: Kioxia Corporation, Tokyo 108-0023 (JP)
(72) Inventor: Ueda, Masaki, Tokyo, 108-0023 (JP)
(74) Representative: Marks & Clerk LLP

(57) **Abstract**

A transfer device includes: a transfer hand configured to transfer a semiconductor wafer; a guide connected to the transfer hand and configured to support the semiconductor wafer; and a component provided under the guide and adjustable of a height of a contact point between the guide and the semiconductor wafer according to a warp shape of the semiconductor wafer.

## Description

### CROSS-REFERENCE TO RELATED APPLICATIONS

This application is based upon and claims the benefit of priority from Japanese Patent Application No. 2025-043153, filed on March 18, 2025.

### FIELD

Embodiments relate to a transfer device, a semiconductor manufacturing device, and a method of manufacturing a semiconductor device.

### BACKGROUND

It is known that semiconductor devices such as three-dimensional memories are manufactured through a film deposition process and heat treatment using a semiconductor manufacturing device.

### BRIEF DESCRIPTION OF THE DRAWINGS

FIG. 1 is a schematic view illustrating an embodiment configuration of a semiconductor manufacturing device.
FIG. 2 is a schematic top view illustrating an embodiment structure of a transfer device 41.
FIG. 3 is a schematic top view illustrating another embodiment structure of the transfer device 41.
FIG. 4 is a schematic top view illustrating another embodiment structure of the transfer device 41.
FIG. 5 is a schematic view illustrating an embodiment of semiconductor wafers 10.
FIG. 6 is a schematic view illustrating an embodiment of the semiconductor wafers 10.
FIG. 7 is a schematic view illustrating an embodiment of the semiconductor wafer 10.
FIG. 8 is a schematic sectional view illustrating an embodiment structure of a component in a first embodiment.
FIG. 9 is a schematic bottom view illustrating the embodiment structure of the component in the first embodiment.
FIG. 10 is a schematic sectional view illustrating a further embodiment of the first embodiment.
FIG. 11 is a schematic sectional view illustrating an embodiment structure of a component in a second embodiment.
FIG. 12 is a schematic sectional view illustrating the embodiment structure of the component in the second embodiment.
FIG. 13 is a schematic sectional view illustrating a further embodiment of the second embodiment.
FIG. 14 is a schematic top view illustrating a further embodiment of the transfer device 41.
FIG. 15 is a schematic top view illustrating a further embodiment of the transfer device 41.
FIG. 16 is a schematic top view illustrating a further embodiment of the transfer device 41.
FIG. 17 is a schematic top view illustrating a further embodiment of the transfer device 41.
FIG. 18 is a schematic sectional view illustrating a further embodiment of the transfer device 41.
FIG. 19 is a schematic sectional view illustrating the further embodiment of the transfer device 41.

### DETAILED DESCRIPTION

Embodiments will be hereinafter described with reference to the drawings. The relation between thickness and planar dimensions of each constituent element, the thickness ratio among the constituent elements, and so on may differ from actual ones. Further, in the embodiments, substantially the same constituent elements are denoted by the same reference signs and a description thereof will be omitted.

### (Semiconductor Manufacturing Device)

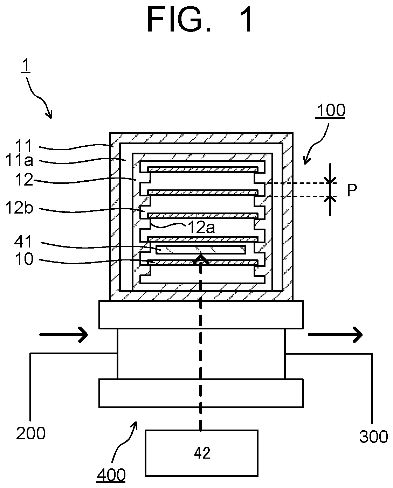

FIG. 1 is a schematic view illustrating an embodiment configuration of a semiconductor manufacturing device. FIG. 1 illustrates an embodiment configuration of a vertical LP-CVD (Low Pressure Chemical Vapor Deposition) device 1. It should be noted that the semiconductor manufacturing device of this embodiment is not limited to the LP-CVD device.

The LP-CVD device 1 includes a processing unit 100, a gas supply unit 200 for gas supply to the processing unit 100, a gas discharge unit 300 for gas discharge from the processing unit 100, and a transfer unit 400 for performing the loading, unloading, and so on of semiconductor wafers 10 to/from the processing unit 100. FIG. 1 further illustrates gas flows, which are indicated by the arrows. The LP-CVD device 1 further has an electrode connected to a not-illustrated power source and configured to apply a voltage from the power source to the processing unit 100.

The processing unit 100 includes a process vessel 11. The process vessel 11 has a space 11a for housing a boat 12. A heater may be provided around the process vessel 11. The space 11a forms a process chamber where to process the semiconductor wafers 10. Examples of the processing of the semiconductor wafers 10 include a film deposition process for forming films on surfaces of the semiconductor wafers 10 by introducing a source gas and heat treatment for annealing the semiconductor wafers 10, in a semiconductor device manufacturing method.

The boat 12 is a carrier for housing the semiconductor wafers 10. The boat 12 has a space 12b where to house the semiconductor wafers 10. The peripheral edges of the semiconductor wafers 10 are held on, for example, holding parts 12a of the boat 12. The holding parts 12a are projections provided on the inner surface of the boat 12 and projecting toward the inside of the boat 12. The boat 12 has the plurality of holding parts 12a arranged along the vertical direction. Intervals between the plurality of holding parts 12a form gaps where to place the semiconductor wafers 10. The pitch P between the holding parts 12a, which is the length of each of the gaps, differs depending on the size of the semiconductor wafers 10 and the specifications of the LP-CVD device 1 and thus is not limited, but is, for example, 6 mm or more.

The semiconductor wafers 10 are, for example, semiconductor substrates to be processed by LP-CVD. Examples of the semiconductor wafer 10 include a semiconductor wafer that has been fabricated into a semiconductor device or that is in the process of being fabricated into a semiconductor device. The semiconductor wafers 10 include silicon wafers.

The gas supply unit 200 is capable of controlling the gas supply to the processing unit 100, for instance. The gas supply unit 200 is capable of supplying, for example, a source gas and an inert gas to the space 11a. The gas supply unit 200 includes, for example, at least one gas supply source, a flow rate regulator for regulating the flow rate of the gas from the gas supply source, and a pipe connecting the gas supply source and the processing unit 100 with the flow rate regulator therebetween.

The gas discharge unit 300 controls the discharge of an exhaust gas from the processing unit 100. The gas discharge unit 300 includes, for example, a pipe in which the exhaust gas discharged from the space 11a flows, a pressure controller for controlling the pressure of an exhaust path including the pipe, an abatement device for removing a harmful substance in the exhaust gas by processing the exhaust gas, and a pump for sending the exhaust gas to the abatement device.

The transfer unit 400 is arranged under the processing unit 100. The transfer unit 400 has a transfer device 41. The transfer device 41 is capable of loading/unloading the semiconductor wafers 10 to/from the processing unit 100 under the control by a control device 42. The control device 42 is constituted using, for example, hardware using a processor or the like. These operations may be stored as an operation program in a computer-readable recording medium such as a memory and executed by the hardware reading the operation program stored in the recording medium when necessary. The control device 42 may have the above-mentioned memory. For example, to control the process of manufacturing a semiconductor device using the semiconductor wafer 10, the control device 42 may control the transfer device 41 using information obtained inside the LP-CVD device 1 or information obtained through communication with the external part of the LP-CVD device 1.

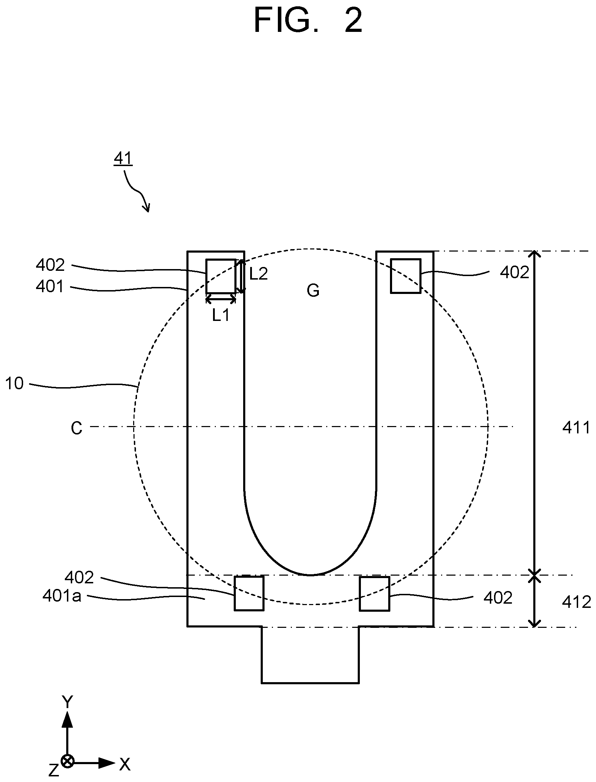

FIG. 2 is a schematic top view illustrating an embodiment structure of the transfer device 41. FIG. 2 indicates an X-axis, a Y-axis, and a Z-axis. The X-axis, the Y-axis, and the Z-axis intersect with one another perpendicularly.

The transfer device 41 has a transfer hand 401 and a guide 402. The X-axis direction and the Y-axis direction are planar directions of the transfer hand 401 and the guide 402. The Z-axis direction is a thickness direction of the transfer hand 401 and the guide 402.

The transfer hand 401 includes fork parts 411 and a joint part 412. The transfer hand 401 includes the plurality of fork parts 411. The joint part 412 connects the plurality of fork parts 411. FIG. 2 illustrates the two fork parts 411, but the number of the plurality of fork parts 411 is not limited. The surface of the transfer hand 401 may have, for example, a U-shape.

The fork parts 411 extend, for example, from the joint part 412 in the Y-axis direction parallel to an X-Y plane of the surface 401a. In the X-Y plane, one of the plurality of fork parts 411 and the other one of the plurality of fork parts 411 form a gap G therebetween.

The guide 402 are provided on the surface of the transfer hand 401. When the semiconductor wafer 10 is transferred using the transfer device 41, the guide 402 come into contact with the semiconductor wafer 10 to support the semiconductor wafer 10. The transfer device 41 has the plurality of the guides 402. The plurality of guides 402 are arranged, for example, at such positions that they will overlap with the edge of the semiconductor wafer 10. For example, the guides 402 are preferably arranged such that they will sandwich the center line C, of the semiconductor wafer 10, perpendicular to the major axis direction of the surface of the transfer hand 401, with one or more on each side of the center line C and with two or more on at least one side of the center line C.

The lateral length L1 and the vertical length L2 of each of the guides 402 on the X-Y plane are not limited, but are 5 cm or less, for instance. The Z-axis-direction thickness of the guide 402 is not limited, and, for example, is not less than 0.5 mm nor more than 5.0 mm. The guide 402 may come into point contact with the semiconductor wafer 10, and the size of the guide 402 is preferably as small as possible according to the specifications such as strength required of the guide 402.

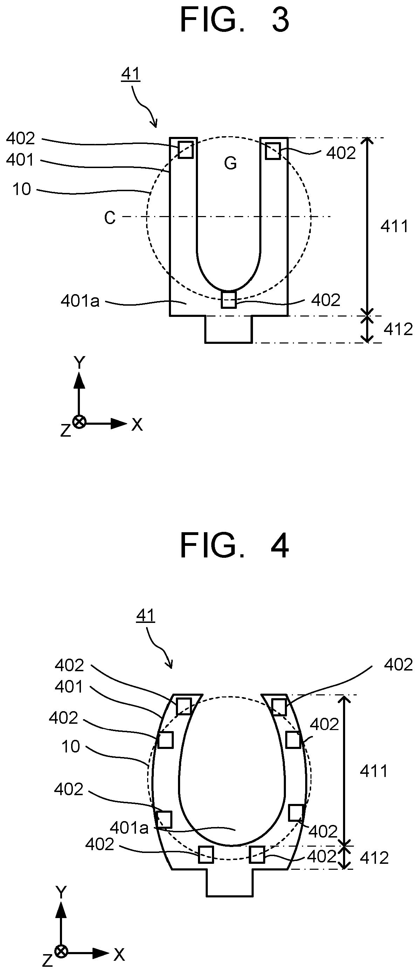

FIG. 2 illustrates the four guides 402, but the number of the plurality of guides 402 is not limited. FIG. 3 and FIG. 4 are schematic top views illustrating other embodiment structures of the transfer device 41. FIG. 3 illustrates an embodiment where it has three guides 402. FIG. 4 illustrates an embodiment where it has eight guides 402. The surface of the transfer hand 401 may have a horseshoe shape as illustrated in FIG. 4. For the other descriptions of FIG. 3 and FIG. 4, the description of FIG. 2 can be referred to as required.

When the processing such as a film deposition process and heat treatment is executed using the LP-CVD device 1, the semiconductor wafer 10 sometimes warps. Further, the warp direction of the semiconductor wafer 10 before the processing may change after the processing.

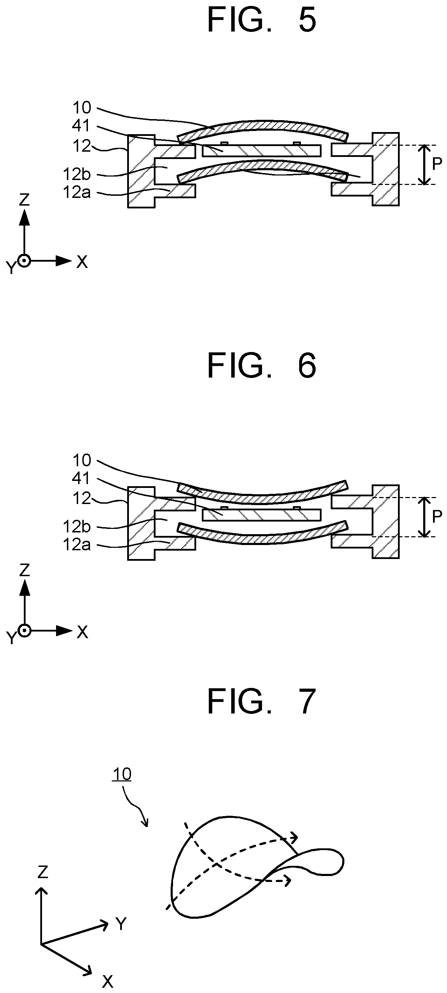

FIG. 5 is a schematic view illustrating an embodiment of the semiconductor wafers 10 housed in the boat 12 and each having a warp curving upward along the Z-axis direction. FIG. 6 is a schematic view illustrating an embodiment of the semiconductor wafers 10 housed in the boat 12 and each having a warp curving downward along the Z-axis direction.

FIG. 7 is a schematic view illustrating an embodiment of the semiconductor wafer 10 having a three-dimensional warp. As illustrated in FIG. 7, with respect to the Z-axis direction and the Y-axis direction, the semiconductor wafer 10 sometimes warps in different directions after it is processed. FIG. 7 illustrates an embodiment where it curves downward with respect to the X-axis direction, while it curves upward with respect to the Y-axis direction, but the shape of the warp is not limited to this.

To unload the semiconductor wafer 10 housed in the boat 12, the transfer device 41 needs to be inserted between the semiconductor wafers 10, but when the semiconductor wafer 10 has a large warp, since the interval between the semiconductor wafers 10 is narrow, it is necessary to widen the vertical-direction pitch P of the holding parts 12a of the boat 12 so that the transfer device 41 and the semiconductor wafer 10 do not come into contact at an unnecessary place. This will be a cause to lower productivity because the number of the semiconductor wafers 10 arrangeable in the boat 12 reduces.

Another possible measure to prevent the contact between the transfer device 41 and the semiconductor wafer 10 at an unnecessary place is to form a groove in the surface of the transfer hand 401 to prevent its contact with the semiconductor wafer 10.
However, this increases the thickness of the transfer hand 401 to narrow warp tolerance.

Therefore, a semiconductor manufacturing device including the transfer device of the embodiments has a component adjustable of the height of a contact point between the transfer device 41 and the semiconductor wafer 10. Specific embodiments of the component will be described below.

### (First Embodiment)

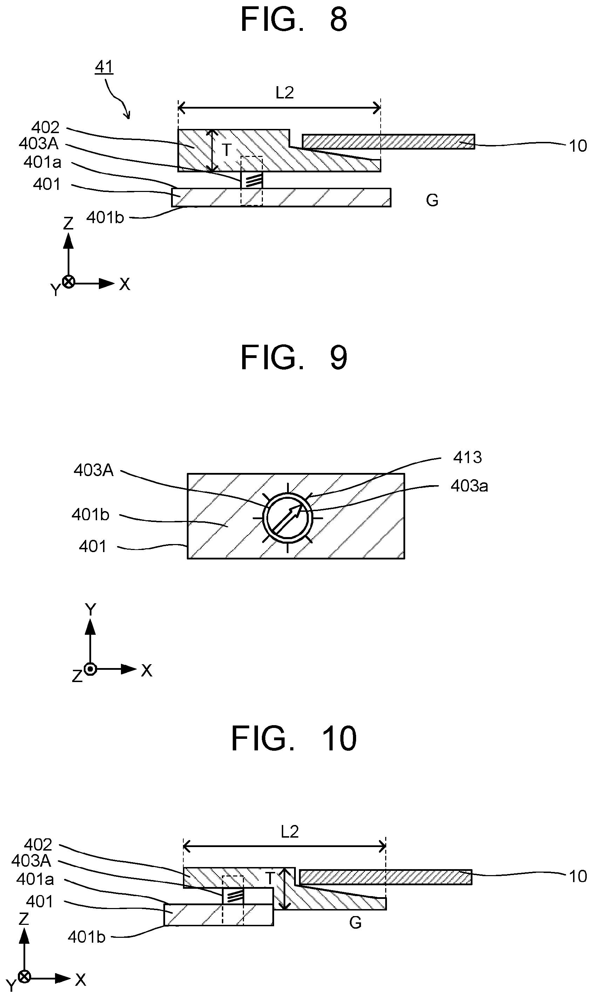

FIG. 8 is a schematic sectional view illustrating an embodiment structure of the component in a first embodiment. FIG. 8 illustrates the transfer hand 401, the guide 402, and the peripheral edge of the semiconductor wafer 10. FIG. 8 further indicates the vertical length L2 of the guide 402 and the thickness T of the guide 402.

The transfer device 41 further has a screw 403A such as a set screw as the above-mentioned component. The screw 403A is provided under the guide 402. The screw 403A penetrates the transfer hand 401 in the Z-axis direction perpendicular to the surface 401a and extends into the guide 402 to be engaged with the guide 402. Rotating the screw 403A causes a thread part of the screw 403A to advance in the Z-axis direction in the transfer hand 401, making it possible to change the height of the guide 402. The transfer device 41 may have a plurality of screws 403A per guide 402.

For example, in the case where the semiconductor wafer 10 warps upward as illustrated in FIG. 5, the height of the guide 402 from the surface 401a is preferably adjusted to be lower than a reference value. On the other hand, in the case where the semiconductor wafer 10 warps downward as illustrated in FIG. 6, the height of the guide 402 from the surface 401a is preferably adjusted to be higher than the reference value.

FIG. 9 is a schematic bottom view illustrating the embodiment structure of the component in the first embodiment. FIG. 9 illustrates a schematic view as viewed from a surface 401b side opposite the surface 401a of the transfer hand 401.

The thread part of the screw 403A may be smaller than an opening of the transfer hand 401. Consequently, it is possible to adjust the interval between the transfer hand 401 and the guide 402 by rotating the screw 403A without the transfer hand 401 rotating. The screw 403A may have a groove (slot) 403a incised in its head part. Examples of the shape of the groove 403a include a shape having a direction such as an arrow. Further, the surface 401b may have calibrations 413 of a dial type incised around the groove 403a. In the case of adjusting the height of the guide 402 by rotating the screw 403A, the combination of the groove 403a and the calibrations 413 makes it possible to confirm the height of the guide 402 by checking the direction of the groove 403a, enabling the quantitative adjustment of the height of the guide 402.

FIG. 10 is a schematic sectional view illustrating a further embodiment of the first embodiment. As illustrated in FIG. 10, the guide 402 may be shaped to extend into the gap G along a direction parallel to the surface 401a, for instance. FIG. 10 illustrates an embodiment where the guide 402 comes into contact with the peripheral edge of the semiconductor wafer 10 above the gap G, but this is not limiting. For the other description of FIG. 10, the descriptions of FIG. 8 and FIG. 9 can be referred to as required.

As described above, in the first embodiment, by adjusting the height of the guide 402 from the surface 401a using the screw 403A, it is possible to adjust the height of the contact plane between the guide 402 and the semiconductor wafer 10 according to the warp shape of the semiconductor wafer 10 before processing the semiconductor wafer 10, for instance. Therefore, it is possible to reduce the unnecessary contact between the transfer device 41 and the semiconductor wafer 10. Further, even if the direction of the warp differs vertically depending on the use, it is possible to change the height of the contact plane between the guide 402 and the semiconductor wafer 10 using the screw 403A according to the use. Therefore, it is possible to widen warp tolerance without widening the pitch P of the holding parts 12a or without changing the guides 402. Further, in the case where the semiconductor wafer 10 has a complicated warp as illustrated in FIG. 7, by, for example, providing the screw 403A for each of the plurality of guides 402, it is possible to adjust the heights of the plurality of guides 402 individually. Therefore, it is possible to reduce the unnecessary contact between the transfer device 41 and the semiconductor wafer 10 caused by a warp of the semiconductor wafer 10.

### (Second Embodiment)

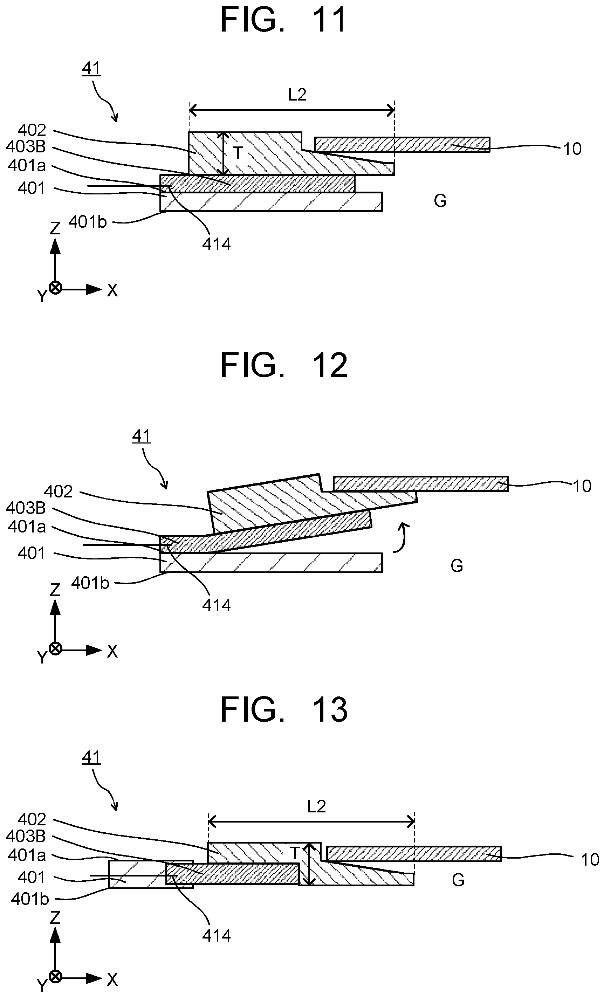

FIG. 11 and FIG. 12 are schematic sectional views illustrating an embodiment structure of the component in a second embodiment. FIG. 11 and FIG. 12 illustrate the transfer hand 401, the guide 402, and the peripheral edge of the semiconductor wafer 10. FIG. 11 further indicates the vertical length L2 of the guide 402 and the thickness T of the guide 402.

The transfer device 41 further has a piezoelectric element 403B as the above-mentioned component. The piezoelectric element 403B is provided under the guide 402 and fixed to the bottom of the guide 402. The piezoelectric element 403B is fixed to the surface 401a at its end part, and its other part only needs to be in contact with the surface 401a without being fixed. The piezoelectric element 403B is connected to, for example, the control device 42 through a wiring line 414. The piezoelectric element 403B changes in shape so as to, for example, bend upward according to a voltage applied from the control device 42. As illustrated in FIG. 12, the piezoelectric element 403B is changeable of the height of the guide 402 by changing its deformation amount according to the applied voltage. The transfer device 41 may have a plurality of the piezoelectric elements 403B per guide 402.

For example, in the case where the semiconductor wafer 10 warps upward as illustrated in FIG. 5, the height of the guide 402 from the surface 401a is preferably adjusted to be lower than the reference value. On the other hand, in the case where the semiconductor wafer 10 warps downward as illustrated in FIG. 6, the height of the guide 402 from the surface 401a is preferably adjusted to be higher than the reference value.

FIG. 13 is a schematic sectional view illustrating a further embodiment of the second embodiment. As illustrated in FIG. 13, the guide 402 may be arranged to, for example, extend along a direction parallel to the surface 401a into the gap G from the surface 401a. FIG. 13 illustrates an embodiment where the guide 402 comes into contact with the semiconductor wafer 10 above the gap G, but this is not limiting. Further, the wiring line 414 may extend into the transfer hand 401. For the other description of FIG. 13, the descriptions of FIG. 11 and FIG. 12 can be referred to as required.

As described above, in the second embodiment, by adjusting the height of the guide 402 from the surface 401a using the piezoelectric element 403B, it is possible to adjust the height of the contact plane between the guide 402 and the semiconductor wafer 10 according to the warp shape of the semiconductor wafer 10 before processing the semiconductor wafer 10, for instance. Further, even if the warp direction differs vertically depending on the use, it is possible to change the height of the contact plane between the guide 402 and the semiconductor wafer 10 according to the use using the piezoelectric element 403B, making it possible to widen warp tolerance without widening the pitch P of the holding parts 12a or without changing the guides 402. Further, even if the semiconductor wafer 10 has a complicated warp as illustrated in FIG. 7, by, for example, providing the piezoelectric element 403B for each of the plurality of guides 402, it is possible to adjust the heights of the plurality of guides 402 individually. Therefore, it is possible to reduce the unnecessary contact between the transfer device 41 and the semiconductor wafer 10 caused by a warp of the semiconductor wafer 10.

To control the process of manufacturing a semiconductor device using the semiconductor wafer 10, the control device 42 may control the voltages that are to be applied to the piezoelectric elements 403B, to adjust the heights of the guides 402 from the surface 401a, using information obtained inside the LP-CVD device 1 or information obtained through communication with the external part of the LP-CVD device 1. For example, by predicting a warp that may occur after the processing based on information on a warp of the semiconductor wafer measured before the processing or information such as a warp variation amount and processing conditions of the semiconductor wafers 10 of a lot processed in the past, it is possible to automatically adjust the guides 420 so that their preprocessing and post-processing heights become suitable for the warp of the semiconductor wafer 10.

### (Further Embodiments of Transfer Device)

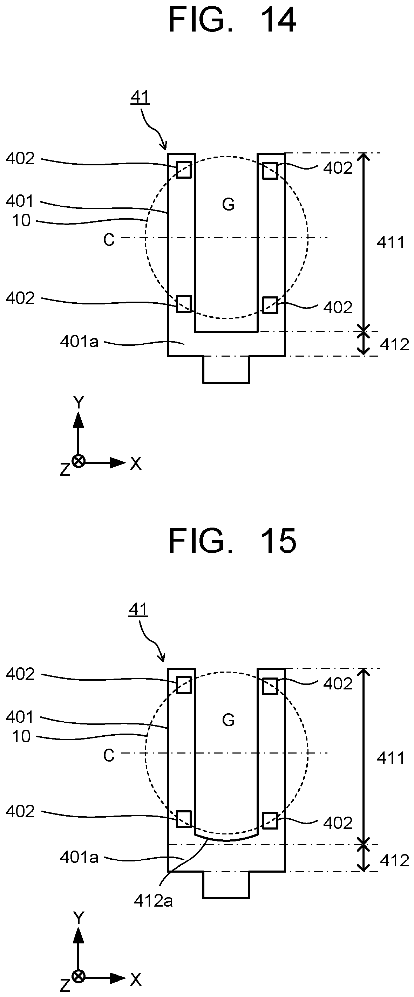

FIG. 14 is a schematic top view illustrating a further embodiment of the transfer device 41. FIG. 14 illustrates an embodiment with four guides 402. The transfer device 41 illustrated in FIG. 14 has a structure in which the plurality of fork parts 11 are not connected to each other under the semiconductor wafer 10 when the semiconductor wafer 10 is placed. In other words, the transfer device 41 illustrated in FIG. 14 has a structure in which the semiconductor wafer 10 is apart from the joint part 412 in the Y-axis direction when the semiconductor wafer 10 is placed. A method of forming the above-described structure is not limited, and an embodiment thereof is a method of making the plurality of fork parts 411 have a length in the Y-axis direction longer than the diameter of the semiconductor wafer 10. In this case, the four guides 402 are provided on the proximal end sides (joint part 412 sides) and the distal end sides (opposite the joint part 412) of the plurality of fork parts 411. For the other description of FIG. 14, the description of FIG. 2 can be referred to as required.

Providing the above-described structure can prevent the transfer hand 401 and the semiconductor wafer 10 from coming into contact with each other on the lower side of the semiconductor wafer 10, making it possible to reduce the unnecessary contact between the transfer device 41 and the semiconductor wafer 10 due to a warp of the semiconductor wafer 10 without increasing the height of the guides 402 or the thickness of the transfer hand 401. The above-described structure is particularly effective in the case where the semiconductor wafer 10 curves downward.

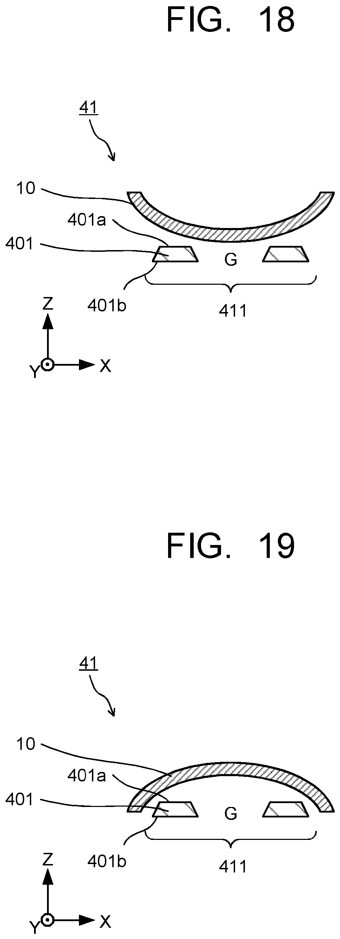

A further embodiment of the transfer device 41 is not limited to the structure illustrated in FIG. 14. FIG. 15, FIG. 16, and FIG. 17 are schematic top views illustrating other embodiment structures of the transfer device 41. FIG. 18 and FIG. 19 are schematic sectional views illustrating another embodiment structure of the transfer device 41.

The transfer device 41 illustrated in FIG. 15 is different from the transfer device 41 illustrated in FIG. 14 at least in that the joint part 412 has an inner surface 412a that is a curved surface facing the placed semiconductor wafer 10 in the Y-axis direction and curving along the peripheral edge of the semiconductor wafer 10. The curvature of the inner surface 412a is preferably equal to the curvature of the edge portion of the semiconductor wafer 10. Forming the inner surface 412a as the curved surface can, for example, increase the cross-section area of the joint part 412, enabling an improvement in the rigidity of the transfer hand 401. Therefore, it is possible to reduce the deformation of the transfer hand 401 due to the placement of the semiconductor wafer 10.

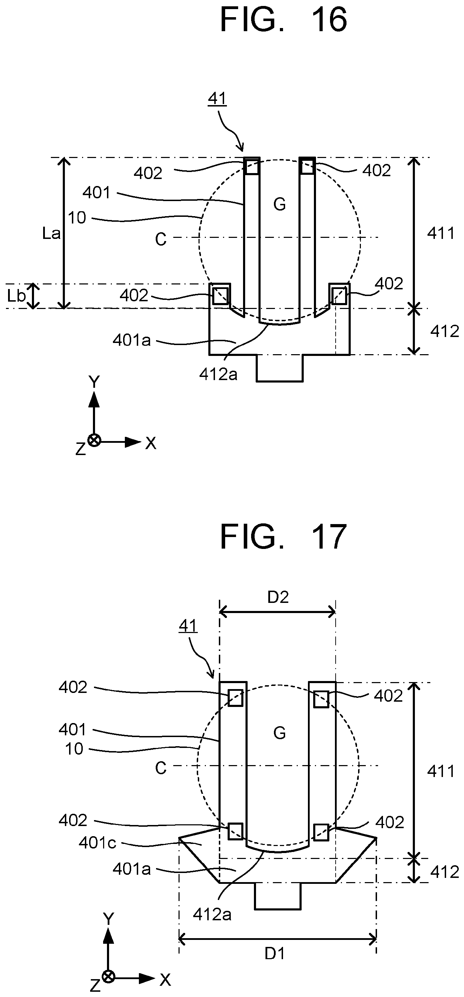

The transfer device 41 illustrated in FIG. 16 is different from the transfer device 41 illustrated in FIG. 15 at least in that it has four fork parts 411. Two of the four fork parts 411 are arranged in the X-axis direction and each have a first length La in the Y-axis direction. The other two of the four fork parts 411 are provided on the X-axis-direction outer sides of the fork parts 411 having the first length La, and each have a second length Lb in the Y-axis direction shorter than the first length La. In this case, the four guides 402 are provided on the distal end sides (opposite the joint part 412) of the plurality of fork parts 411 respectively. Providing the plurality of fork parts 411 having different lengths in the Y-axis direction can reduce the load applied to the longer fork parts 411 when the semiconductor wafer 10 is placed. Therefore, it is possible to reduce the deformation of the transfer hand 401 due to the placement of the semiconductor wafer 10.

The transfer device 41 illustrated in FIG. 17 is different from the transfer device 41 illustrated in FIG. 15 at least in that it has a structure in which an X-axis-direction width D1 of the joint part 412 is larger than an X-axis-direction distance D2 between the most distant fork parts 411. A method of widening the width D1 of the joint part 412 is not limited, and an embodiment thereof is a method of providing overhanging portions 401c. The overhanging portions 401c are projections projecting more outward than the fork parts 411 in the X-axis direction. The planar shape of the overhanging portions 401c is not limited, and is triangular, for instance. The overhanging portions 401c may extend from the joint part 412 in the Y-axis direction along part of the fork parts 411. The overhanging portions 401c are preferably apart from the semiconductor wafer 10 when the semiconductor wafer 10 is placed. Providing the overhanging portions 401c can, for example, increase the cross-section area of the joint part 412, enabling an improvement in the rigidity of the transfer hand 401. Therefore, it is possible to reduce the deformation of the transfer hand 401 due to the placement of the semiconductor wafer 10.

The transfer device 41 illustrated in FIG. 18 and FIG. 19 is different from the transfer device 41 illustrated in FIG. 15 at least in that, in its cross section including the X-axis direction and the Z-axis direction, the upper surfaces (surfaces 401a) of the fork parts 411 are narrower in width in the X-axis direction than the lower surfaces (surfaces 401b) of the fork parts 411. The shape of the X-Z sections of the fork parts 411 is not limited, and is trapezoidal, for instance. Narrowing the width of the upper surfaces of the fork parts 411 can extend the distance between the fork parts 411 and the semiconductor wafer 10. This reduces the height of the guide 402 required to avoid contact between the fork part 411 and the semiconductor wafer 10. The above-described structure is particularly effective in the case where the semiconductor wafer 10 curves downward as illustrated in FIG. 18 or the case where the semiconductor wafer 10 curves upward as illustrated in FIG. 19. Further, this can easily make the sectional area larger than in the case where the X-Z sections of the fork parts 411 are rectangular, enabling an improvement in the rigidity of the transfer hand 401. Therefore, it is possible to reduce the deformation of the transfer hand 401 due to the placement of the semiconductor wafer 10.

The further embodiments of the transfer device 41 illustrated in FIG. 14 to FIG. 19 can be appropriately combined with the first embodiment and the second embodiment. This is not limiting, and the further embodiments of the transfer device 41 illustrated in FIG. 14 to FIG. 19 do not necessarily have the component that is adjustable of the height of the contact point between the transfer device 41 and the semiconductor wafer 10 as described in the first embodiment and the second embodiment.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

Further embodiments are as followed.
(Embodiment 1) A transfer device comprising:
   a transfer hand configured to transfer a semiconductor wafer;
   a guide connected to the transfer hand and configured to support the semiconductor wafer; and
   a component provided under the guide and adjustable of a height of a contact point between the guide and the semiconductor wafer according to a warp shape of the semiconductor wafer.
(Embodiment 2) The transfer device according to embodiment 1,
   wherein the transfer hand has:
   a plurality of fork parts extending in a first direction parallel to a surface of the transfer hand; and
   a joint part connecting the plurality of fork parts, and
   wherein the guide is provided on the surface of the transfer hand and extends along a second direction parallel to the surface of the transfer hand from the surface of the transfer hand into a gap between one of the plurality of fork parts and another of the plurality of fork parts.
(Embodiment 3) 3. The transfer device according to embodiment 1,
   wherein the component includes a screw penetrating the transfer hand along a third direction perpendicular to a surface of the transfer hand to be engaged with the guide and adjustable of a height of the guide from the surface of the transfer hand.
(Embodiment 4) 4. The transfer device according to embodiment 1,
   wherein the component is fixed to a bottom of the guide and is changeable in shape.
(Embodiment 5) The transfer device according to embodiment 4,
   wherein a deformation amount of the component is controlled using information obtained inside a semiconductor manufacturing device including the transfer device or information obtained through communication with an external part of the semiconductor manufacturing device for controlling a process of manufacturing a semiconductor device using the semiconductor wafer.
(Embodiment 6) The transfer device according to embodiment 1,
   wherein the guide includes a plurality of the guides, and
   wherein the component is provided for each of the plurality of the guides.
(Embodiment 7) The transfer device according to embodiment 2,
   wherein the joint part is apart from the semiconductor wafer in the first direction when the semiconductor wafer is placed.
(Embodiment 8) The transfer device according to embodiment 2,
   wherein the joint part has an inner surface that is a curved surface facing on the semiconductor wafer to be placed in the first direction and curving along a peripheral edge of the semiconductor wafer to be placed.
(Embodiment 9) The transfer device according to embodiment 2,
   wherein the plurality of fork parts include:
   a plurality of first fork parts each having a first length in the first direction; and
   a plurality of second fork parts provided on outer sides of the plurality of first fork parts in a fourth direction perpendicular to the first direction and each having a second length in the first direction shorter than the first length.
(Embodiment 10) The transfer device according to embodiment 2,
   wherein a width in a fourth direction perpendicular to the first direction, of the joint part is larger than a distance in the fourth direction between the most distant plurality of fork parts.
(Embodiment 11) The transfer device according to embodiment 2,
   wherein, in a cross section, of one of the plurality of fork parts, including a third direction perpendicular to the surface of the transfer hand and a fourth direction perpendicular to the first direction, an upper surface of the one of the plurality of fork parts is narrower in width in the fourth direction than a lower surface of the one of the plurality of fork parts.
(Embodiment 12) A method of manufacturing a semiconductor device, comprising:
   placing a semiconductor wafer in a boat housed in a vessel using a transfer device; and
   processing the semiconductor wafer in the vessel,
   wherein the transfer device has:
      a transfer hand configured to transfer the semiconductor wafer;
      a guide connected to the transfer hand and configured to support the semiconductor wafer; and
      a component adjustable of a height of a contact point between the guide and the semiconductor wafer, and
      wherein the height of the contact point between the guide and the semiconductor wafer is adjusted according to a warp shape of the semiconductor wafer before the semiconductor wafer is processed.
(Embodiment 13) The method according to embodiment 12,
   wherein the transfer hand has:
   a plurality of fork parts extending in a first direction parallel to a surface of the transfer hand; and
   a joint part connecting the plurality of fork parts, and
   wherein the guide is provided on the surface of the transfer hand and extends along a second direction parallel to the surface of the transfer hand from the surface of the transfer hand into a gap between one of the plurality of fork parts and another of the plurality of fork parts.
(Embodiment 14) The method according to embodiment 12,
   wherein the component includes a screw penetrating the transfer hand along a third direction perpendicular to a surface of the transfer hand to be engaged with the guide and adjustable of a height of the guide from the surface of the transfer hand.
(Embodiment 15) The method according to embodiment 12,
   wherein the component is fixed to a bottom of the guide and is changeable in shape, and/or
   wherein a deformation amount of the component is controlled using information obtained inside a semiconductor manufacturing device including the transfer device or information obtained through communication with an external part of the semiconductor manufacturing device for controlling a process of manufacturing a semiconductor device using the semiconductor wafer.

## Claims

1. A transfer device (41) comprising:
a transfer hand (401) configured to transfer a semiconductor wafer (10);
a guide (402) connected to the transfer hand (401) and configured to support the semiconductor wafer (10); and
a component provided under the guide (402) and adjustable of a height of a contact point between the guide (402) and the semiconductor wafer (10) according to a warp shape of the semiconductor wafer (10).

2. The transfer device (41) according to claim 1,
wherein the transfer hand (401) has:
a plurality of fork parts (411) extending in a first direction parallel to a surface of the transfer hand (401); and
a joint part (412) connecting the plurality of fork parts (411), and
wherein the guide (402) is provided on the surface of the transfer hand (401) and extends along a second direction parallel to the surface of the transfer hand (401) from the surface of the transfer hand (401) into a gap between one of the plurality of fork parts (411) and another of the plurality of fork parts (411).

3. The transfer device (41) according to claim 1,
wherein the component includes a screw (403A) penetrating the transfer hand (401) along a third direction perpendicular to a surface of the transfer hand (401) to be engaged with the guide (402) and adjustable of a height of the guide (402) from the surface of the transfer hand (401).

4. The transfer device (41) according to claim 1,
wherein the component is fixed to a bottom of the guide (402) and is changeable in shape.

5. The transfer device (41) according to claim 4,
wherein a deformation amount of the component is controlled using information obtained inside a semiconductor manufacturing device including the transfer device (41) or information obtained through communication with an external part of the semiconductor manufacturing device for controlling a process of manufacturing a semiconductor device using the semiconductor wafer (10).

6. The transfer device (41) according to claim 1,
wherein the guide (402) includes a plurality of the guides (402), and
wherein the component is provided for each of the plurality of the guides (402).

7. The transfer device (41) according to claim 2,
wherein the joint part (412) is apart from the semiconductor wafer (10) in the first direction when the semiconductor wafer (10) is placed.

8. The transfer device (41) according to claim 2,
wherein the joint part (412) has an inner surface that is a curved surface facing on the semiconductor wafer (10) to be placed in the first direction and curving along a peripheral edge of the semiconductor wafer (10) to be placed.

9. The transfer device (41) according to claim 2,
wherein the plurality of fork parts (411) include:
a plurality of first fork parts (411) each having a first length in the first direction; and
a plurality of second fork parts (411) provided on outer sides of the plurality of first fork parts (411) in a fourth direction perpendicular to the first direction and each having a second length in the first direction shorter than the first length.

10. The transfer device (41) according to claim 2,
wherein a width in a fourth direction perpendicular to the first direction, of the joint part (412) is larger than a distance in the fourth direction between the most distant plurality of fork parts (411).

11. The transfer device (41) according to claim 2,
wherein, in a cross section, of one of the plurality of fork parts (411), including a third direction perpendicular to the surface of the transfer hand (401) and a fourth direction perpendicular to the first direction, an upper surface of the one of the plurality of fork parts (411) is narrower in width in the fourth direction than a lower surface of the one of the plurality of fork parts (411).

12. A method of manufacturing a semiconductor device, comprising:
placing a semiconductor wafer (10) in a boat housed in a vessel using a transfer device (41); and
processing the semiconductor wafer (10) in the vessel,
wherein the transfer device (41) has:
a transfer hand (401) configured to transfer the semiconductor wafer (10);
a guide (402) connected to the transfer hand (401) and configured to support the semiconductor wafer (10); and
a component adjustable of a height of a contact point between the guide (402) and the semiconductor wafer (10), and
wherein the height of the contact point between the guide (402) and the semiconductor wafer (10) is adjusted according to a warp shape of the semiconductor wafer (10) before the semiconductor wafer (10) is processed.

13. The method according to claim 12,
wherein the transfer hand (401) has:
a plurality of fork parts (411) extending in a first direction parallel to a surface of the transfer hand (401); and
a joint part (412) connecting the plurality of fork parts (411), and
wherein the guide (402) is provided on the surface of the transfer hand (401) and extends along a second direction parallel to the surface of the transfer hand (401) from the surface of the transfer hand (401) into a gap between one of the plurality of fork parts (411) and another of the plurality of fork parts (411).

14. The method according to claim 12,
wherein the component includes a screw (403A) penetrating the transfer hand (401) along a third direction perpendicular to a surface of the transfer hand (401) to be engaged with the guide (402) and adjustable of a height of the guide (402) from the surface of the transfer hand (401).

15. The method according to claim 12,
wherein the component is fixed to a bottom of the guide (402) and is changeable in shape, and/or
wherein a deformation amount of the component is controlled using information obtained inside a semiconductor manufacturing device including the transfer device (41) or information obtained through communication with an external part of the semiconductor manufacturing device for controlling a process of manufacturing a semiconductor device using the semiconductor wafer (10).
